(19) Europäisches Patentamt
European Patent Office
Office européen des brevets

(11) EP 2 190 119 A1

(12) EUROPEAN PATENT APPLICATION

(43) Date of publication:
26.05.2010 Bulletin 2010/21

(51) Int Cl.:
H03L 7/085 (2006.01)    H03L 7/093 (2006.01)

(21) Application number: 09174087.8

(22) Date of filing: 26.10.2009

(84) Designated Contracting States:
AT BE BG CH CY CZ DE DK EE ES FI FR GB GR
HR HU IE IS IT LI LT LU LV MC MK MT NL NO PL
PT RO SE SI SK SM TR
Designated Extension States:
AL BA RS

(30) Priority: 20.11.2008 JP 2008296635

(71) Applicant: Fujitsu Limited
Kawasaki-shi, Kanagawa 211-8588 (JP)

(72) Inventor: Atsumi, Ken
Kawasaki-shi, Kanagawa 211-8588 (JP)

(74) Representative: Stebbing, Timothy Charles
Haseltine Lake LLP
Lincoln House, 5th Floor
300 High Holborn
London WC1V 7JH (GB)

(54) Control apparatus and clock synchronizing method

(57) A control apparatus that performs control to synchronize an output clock signal with an input clock signal includes a counting part (103) that counts a phase difference between the input clock signal and the output clock signal, an extracting part (104) that extracts a count value indicating, of phase differences counted by the counting part, a phase difference within a certain range, and a clock generating part (108) that generates the output clock signal, the clock generating part being capable of controlling a frequency of the output clock signal on the basis of the extracted count value indicating the phase difference within the certain range.

FIG. 2

EP 2 190 119 A1

**Description**

This application is based upon and claims the benefit of priority of the prior Japanese Patent Application No. 2008-296635, filed on November 20, 2008.

The present invention relates to a control apparatus and a clock synchronizing method for controlling clock synchronization.

A communication apparatus such as a wireless communication base station generates, by using, for example, a digital phase locked loop (DPLL) circuit, a system clock signal (e.g., 3.84 MHz) synchronized with a clock signal extracted from a highway (HWY) line which is a digital synchronous network connected to an upper station.

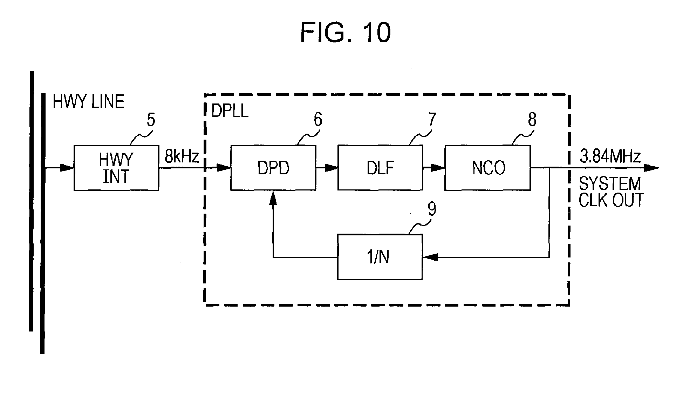

Fig. 10 illustrates a structure example of a DPLL circuit. The DPLL circuit generates an output clock signal whose phase is synchronized with an input clock signal, as with the case of an analog phase locked loop (PLL) circuit (e.g., see Japanese Laid-open Patent Publication No. 2002-152736). In the DPLL circuit, a phase comparator, a loop filter, and an oscillator that are the components of the PLL circuit are configured to process digital signals.

Referring to Fig. 10, the DPLL circuit includes a HWY interface 5, a phase comparator 6, a loop filter 7, an oscillator 8, and a frequency divider 9.

In the example illustrated in Fig. 10, a digital phase detector (DPD) is used as the phase comparator 6; a digital loop filter (DLF) is used as the loop filter 7; and a numerically controlled oscillator (NCO) is used as the oscillator 8.

A clock signal extracted from a HWY line is input via the HWY interface 5 to the phase comparator 6 in the DPLL circuit.

The phase comparator 6 counts the phase difference between the input clock signal from the HWY interface 5 and an output clock signal that is from the oscillator 8 and that is frequency-divided by the frequency divider 9 (the frequency is converted by multiplying it by 1/N), and outputs the counted result as phase difference information in terms of a digital value.

A signal including the phase difference information output from the phase comparator 6 is input via the loop filter 7 to the oscillator 8.

The oscillator 8 changes the output frequency on the basis of the input phase difference information, thereby generating an output clock signal synchronized with the input clock signal from the HWY interface 5 to the phase comparator 6.

The output clock signal from the oscillator 8 is output as a system clock signal from the DPLL circuit. Also, as feedback control, the output clock signal from the oscillator 8 is frequency-divided by the frequency divider 9 and input to the phase comparator 6.

Accordingly, the DPLL circuit generates an output clock signal synchronized with an input clock signal from the HWY line.

Next, the process of generating phase difference information in the phase comparator 6 illustrated in Fig. 10 will be described in detail.

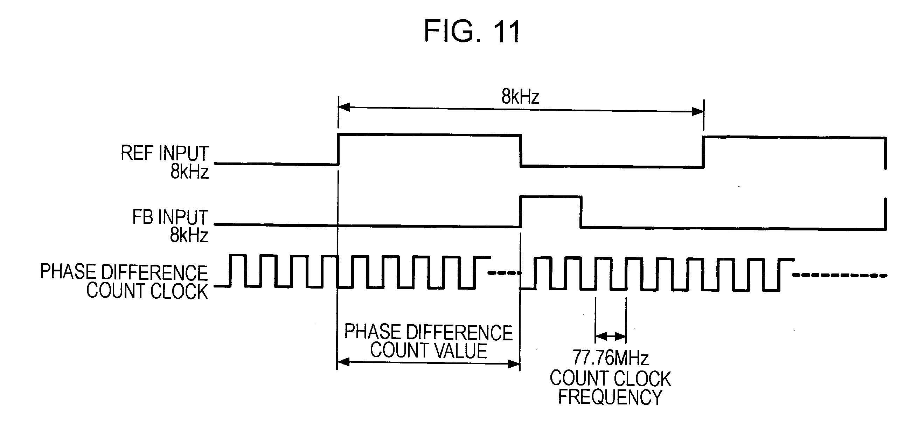

A method of detecting the phase difference between multiple input clock signals in the phase comparator 6 will now be described with reference to Fig. 11.

Referring to Fig. 11, a reference (REF) input clock signal indicates an input clock signal extracted from the HWY line and input to the phase comparator 6. A feedback (FB) input clock signal indicates an output clock signal that is input, so as to perform feedback control, from the oscillator 8 to the phase comparator 6.

A count clock signal is a reference clock signal that is sufficiently fast compared with the REF input clock signal and the FB input clock signal, that is, a high-frequency reference clock signal.

The phase comparator 6 detects the rising edge of the REF input clock signal and the FB input clock signal. The phase comparator 6 counts, using the count clock signal, the phase difference between detection of the rising edge of the REF input clock signal and detection of the rising edge of the FB input clock signal.

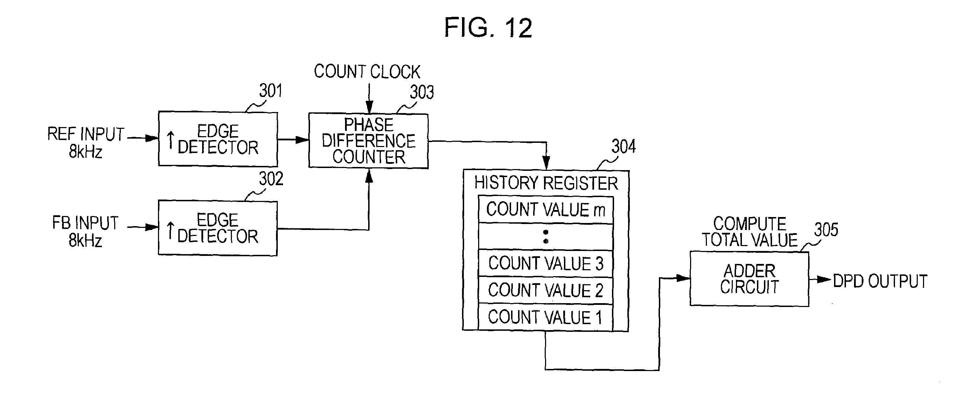

Fig. 12 illustrates a structure example of the phase comparator 6.

Referring to Fig. 12, the phase comparator 6 includes an edge detector 301 that detects the rising edge of the REF input clock signal, an edge detector 302 that detects the rising edge of the FB input clock signal, a phase difference counter 303, a history register 304, and an adder circuit 305.

The edge detector 301 and the edge detector 302 detect the rising edge of the REF input clock signal and the FB input clock signal, respectively, and send detection information to the phase difference counter 303.

The phase difference counter 303 counts, using the count clock signal, the phase difference between the rising edge of the REF input clock signal and the rising edge of the FB input clock signal on the basis of the detection information obtained from the edge detector 301 and the edge detector 302, and stores the counted value (hereinafter referred to as a count value) in the history register 304.

The history register 304 includes multiple registers. In the multiple registers, count values 1 to m counted by the phase difference counter 303 are sequentially stored in cycles of, for example, the reciprocal of the frequency of the REF input clock signal (which may be called comparison frequency).

The adder circuit 305 adds the count values 1 to m stored in the history register 304 and computes the total value. The adder circuit 305 outputs the computed total value as phase difference information.

As a specific example, when the comparison frequency is 8 kHz and the frequency of the count clock signal is 77.76 MHz, the phase difference detection resolution ΔP of the phase comparator 6 will be computed by the following equation 1:

$$\Delta P = 8kHz / 77.76MHz = 0.0001UI / count$$

$$= 2\pi \times 0.0001UI = 0.0006rad / count$$

$$= 0.0006rad / (2\pi \times 8kHz) = 12.8ns / count \qquad [1]$$

When the phase difference between the input clock signals (REF input clock signal and FB input clock signal) input to the phase comparator 6 is 180 degrees in the case where the DPLL circuit is locked, that is, in the case where it is determined that the input clock signal and the output clock signal of the DPLL circuit are synchronized with each other and converge, the count value counted using the count clock signal in the locked state is obtained using the following equation 2:

$$(77.76MHz / 8kHz) \times (180 \deg / 360 \deg) = 4860 count \qquad [2]$$

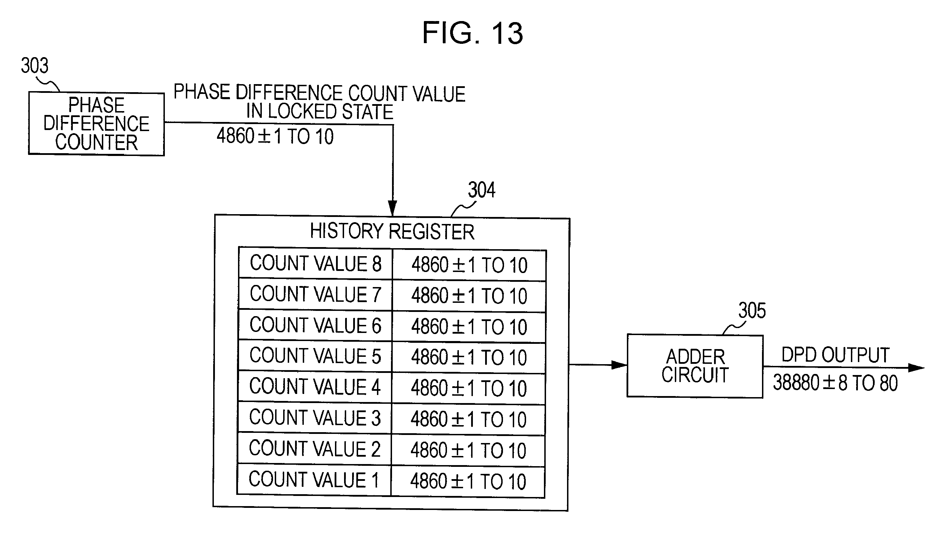

In the foregoing example, the phase difference count value in the locked state changes by 4860. A fluctuation of the count value is normally ±1 to 10 counts in accordance with the degree of stableness of the oscillator 8 (e.g., about 0.1 m to 1 m Unit Interval (UI) in terms of the phase difference). Therefore, each count value stored in the history register 304 will be 4860 ± 1 to 10. For example, as illustrated in Fig. 13, when eight count values are stored in the history register 304, the total value computed by the adder circuit 305 will be 38880 ± 8 to 80.

The input clock signal input to the DPLL circuit may have instantaneous phase jump due to disturbance caused by, for example, noise or cross talk that occurs in the circuit or apparatus. Even when the input clock signal has phase jump, the DPLL circuit generates an output clock signal (which may be called system clock signal) synchronized with the input clock signal. Therefore, the communication apparatus causes a system error.

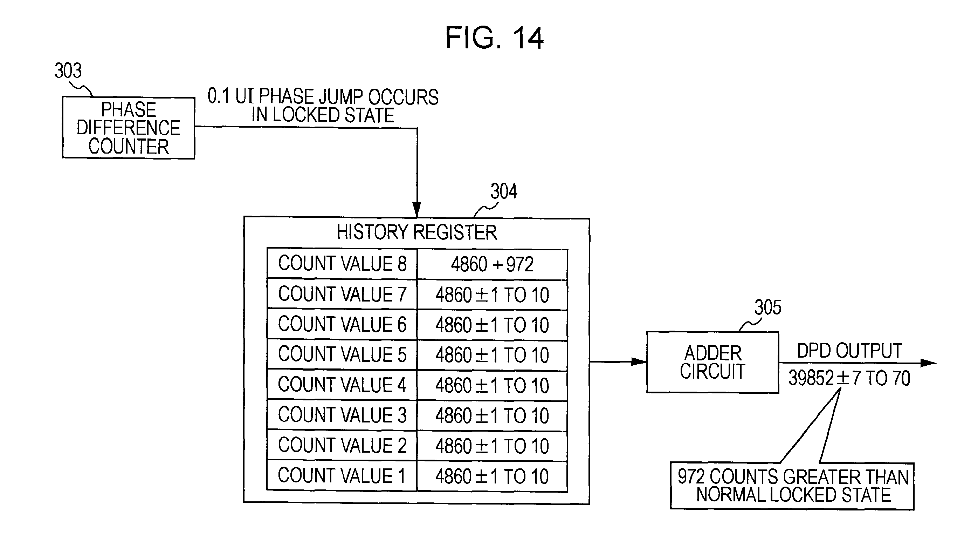

For example, as illustrated in Fig. 14, when 0.1 UI instantaneous phase jump occurs, the count value obtained by the phase difference counter 303 is increased or decreased by 972 counts compared with the count value obtained in the locked state.

The count value based on the phase jump, which is computed by the phase difference counter 303, is input via the loop filter 7 at a subsequent stage to the oscillator 8, and the phase jump affects the output clock signal from the oscillator 8. That is, the output clock signal also has phase jump in accordance with the input clock signal of the DPLL circuit.

In order to overcome the foregoing problem, for example, measures have been taken to change the characteristics of the loop filter 7 provided in the DPLL circuit, that is, to reduce the cut-off frequency of the loop filter 7.

By reducing the cut-off frequency, although the above-described effects of the phase jump may be alleviated, the response characteristics of the DPLL circuit may become slower, or an expensive oscillator with lower phase noise characteristics may become necessary, resulting in an increase in the manufacturing cost. Accordingly, new problems are caused.

Japanese Laid-open Patent Publication No. 2002-152736 discloses the technique of inhibiting, in a PLL circuit, a phase comparator from performing phase comparison when it is determined that phase jump has occurred. However, when the phase comparator is inhibited from performing phase comparison, a voltage controlled crystal oscillator (VCXO) may operate by itself on the basis of a fixed value that is not in accordance with the phase difference between the input and output clock signals. Accordingly, the output clock signal may have a frequency fluctuation in accordance with the accuracy of the VCXO.

Accordingly it is desirable in one aspect of the invention to provide a control apparatus and a clock synchronizing method for suppressing the occurrence of phase jump in an output clock signal due to the effect of instantaneous phase jump that occurs in an input clock signal in a DPLL circuit.

Accordingly it is also desirable in one aspect of the invention to provide a control apparatus and a clock synchronizing method for suppressing the occurrence of phase jump in an output clock signal without changing the setting of the cut-off frequency of a loop filter provided in a DPLL circuit.

According to an aspect of the invention, there is provided a control apparatus that performs control to synchronize an output clock signal with an input clock signal includes a counting part that counts a phase difference between the input clock signal and the output clock signal, an extracting part that extracts a count value indicating, of phase differences counted by the counting part, a phase difference within a certain range, and a clock generating part that generates the output clock signal, the clock generating part being capable of controlling a frequency of the output clock signal on the basis of the extracted count value indicating the phase difference within the certain range.

According to another aspect of the present invention, there is provided a clock synchronizing method for performing control to synchronize an output clock signal with an input clock signal, comprising: counting a phase difference between the input clock signal and the output clock signal; extracting a count value indicating, of counted phase differences, a phase difference within a certain range; and controlling a frequency of the output clock signal to be generated, on the basis of the extracted count value indicating the phase difference within the certain range.

Embodiments of the present invention will now be described with reference to the accompanying drawings, of which:

Fig. 1 illustrates an example of a DPLL circuit;

Fig. 2 illustrates an example of a phase comparator;

Fig. 3 illustrates an operation example of the phase comparator which generates phase difference information in the case where no phase jump occurs;

Fig. 4 illustrates an operation example of a phase-jump determining circuit when phase jump occurs;

Fig. 5 illustrates an operation example of a phase-jump correcting circuit when phase jump occurs;

Fig. 6 illustrates an operation example of a selector circuit when phase jump occurs;

Fig. 7 illustrates an operation example of the phase-jump determining circuit in the case where the occurrence of phase jump is instantaneous;

Fig. 8 illustrates an operation example of the selector circuit in the case where the occurrence of phase jump is instantaneous;

Fig. 9 illustrates an operation example of the phase comparator which generates phase difference information in the case where the occurrence of phase jump is not instantaneous;

Fig. 10 illustrates an example of a DPLL circuit in the related art;

Fig. 11 illustrates a method of detecting a phase difference between multiple input clock signals in a phase comparator;

Fig. 12 illustrates an example of a phase comparator in the related art;

Fig. 13 illustrates an operation example of the phase comparator in the related art, which generates phase difference information (in the case where no phase jump occurs); and

Fig. 14 illustrates an operation example of the phase comparator in the related art, which generates phase difference information in the case where phase jump occurs.

Embodiments will be described with reference to the drawings.

(1) DPLL Circuit

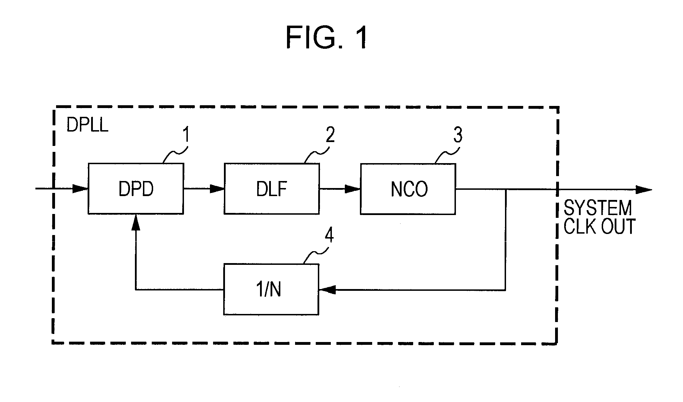

Fig. 1 illustrates an example of a DPLL circuit used in the present embodiment.

Referring to Fig. 1, the DPLL circuit includes a phase comparator 1, a loop filter 2, an oscillator 3, and a frequency divider 4.

For example, a DPD is used as the phase comparator 1; a DLF is used as the loop filter 2; and an NCO is used as the oscillator 3. The loop filter 2 is, for example, an infinite impulse response (IIR) filter, and a digital signal processor (DSP), for example, is used as the loop filter 2.

A clock signal extracted from an external line (e.g., a digital synchronous network connected to an upper station) is input to the phase comparator 1 in the DPLL circuit.

The phase comparator 1 counts the phase difference between the input clock signal extracted from the external line and an output clock signal that is from the oscillator 3 and that is frequency-divided by the frequency divider 4 (the frequency is converted by multiplying it by 1/N), and outputs the counted result as phase difference information in terms of a digital value.

A signal including the phase difference information output from the phase comparator 1 is filtered by the loop filter 2, and the filtered signal is input to the oscillator 3.

The oscillator 3 generates an output clock signal synchronized with the input clock signal, which is input from the external line to the phase comparator 1, by changing the output frequency on the basis of the input phase difference information.

The output clock signal generated by the oscillator 3 is output as a system clock signal from the DPLL circuit. Also, as feedback control, the output clock signal from the oscillator 3 is frequency-divided by the frequency divider 4 and input to the phase comparator 1.

Accordingly, the DPLL circuit of the present embodiment generates an output clock signal synchronized with an input clock signal from the external line.

Hereinafter, a clock signal extracted from the external line and input to the phase comparator 1 will be referred to as a REF input clock signal, and a clock signal output from the oscillator 3, frequency-divided, and then input to the phase comparator 1 will be referred to as a FB input clock signal.

(2) Phase Comparator

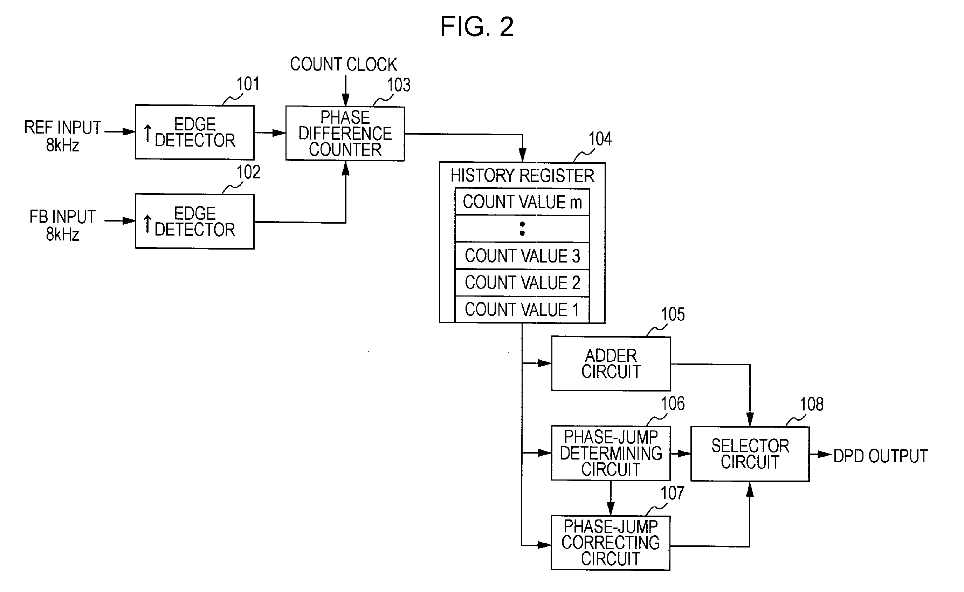

Fig. 2 illustrates an example of the phase comparator used in the present embodiment.

Referring to Fig. 2, the phase comparator 1 includes an edge detector 101 that detects the rising edge of the REF input clock signal, an edge detector 102 that detects the rising edge of the FB input clock signal, a phase difference counter 103, a history register 104, an adder circuit 105, a phase-jump determining circuit 106, a phase-jump correcting circuit 107, and a selector circuit 108.

The edge detector 101 detects the rising edge of the REF input clock signal, and sends detection information to the phase difference counter 103. Similarly, the edge detector 102 detects the rising edge of the FB input clock signal, and sends detection information to the phase difference counter 103.

The phase difference counter 103 counts, using a count clock signal, the phase difference between the rising edge of the REF input clock signal and the rising edge of the FB input clock signal on the basis of the detection information obtained from the edge detector 101 and the edge detector 102 by using, for example, the method described with reference to Fig. 11, and stores the counted value (hereinafter referred to as a count value) in the history register 104.

The history register 104 includes multiple registers. In the multiple registers, count values 1 to m counted by the phase difference counter 103 are sequentially stored. When the count values are updated, that is, when a new count value is stored as a count value 8 in the history register 104, count values 2 to 8 before being updated are shifted to become count values 1 to 7, and the count value 1 before being updated is deleted from the history register 104. The cycle of updating the count values may be the reciprocal of the frequency of the REF input clock signal (comparison frequency).

The adder circuit 105 extracts the count values 1 to m stored in the history register 104 and computes the total value by adding the extracted count values 1 to m. The adder circuit 105 generates phase difference information by using the computed total value, and outputs the phase difference information.

The phase-jump determining circuit 106 extracts the count values stored in the history register 104 and, on the basis of comparison between the extracted count values with a preset count value range, determines whether phase jump has occurred in the REF input clock signal. That is, the phase-jump determining circuit 106 determines that no phase jump has occurred when the count values stored in the history register 104 each indicate a phase difference within a certain range, and determines that phase jump has occurred when any of the count values stored in the history register 104 indicates a phase difference that is not within the certain range.

A count value indicating a phase difference within the certain range, which serves as the foregoing determination criterion in the phase-jump determining circuit 106, may be appropriately set. For example, in the case of a base station apparatus, it is preferable that the count value correspond to a count value in a locked state $\pm$ phase difference 0.1 mUI to 1 mUI.

When the phase-jump determining circuit 106 determines, on the basis of the count values stored in the history register 104, that no phase jump has occurred, the phase-jump determining circuit 106 sends a signal indicating that no phase jump has occurred to the selector circuit 108. When the phase-jump determining circuit 106 determines, on the basis of any of the count values stored in the history register 104, that phase jump has occurred, the phase-jump determining circuit 106 sends a signal indicating that phase jump has occurred to the phase-jump correcting circuit 107 and the selector circuit 108. Alternatively, the phase-jump determining circuit 106 may not necessarily send a signal indicating that no phase jump has occurred to the selector circuit 108 when the phase-jump determining circuit 106 determines that no phase jump has occurred.

Upon receipt of the signal from the phase-jump determining circuit 106 indicating that phase jump has occurred, the phase-jump correcting circuit 107 extracts the count values stored in the history register 104 other than the count value based on which the occurrence of phase jump has been determined. Using values obtained by applying an operation described later to the extracted count values, the phase-jumping correcting circuit 107 generates phase difference information, and outputs the phase difference information.

The items of phase difference information output from the adder circuit and the phase-jump correcting circuit 107 are input to the selector circuit 108.

On the basis of the signal indicating that no phase jump has occurred or the signal indicating that phase jump has occurred, which is received from the phase-jump determining circuit 106, the selector circuit 108 selects the phase difference information to output. That is, when the signal indicating that no phase jump has occurred is received or when no signal indicating that phase jump has occurred is received, the selector circuit 108 outputs the phase difference information from the adder circuit 105. When the signal indicating that phase jump has occurred is received, the selector circuit 108 outputs the phase difference information from the phase-jump correcting circuit 107.

The phase difference information output from the selector circuit 108 is input to the loop filter 2 (which is not illustrated in Fig. 2).

(3) Details of Phase Difference Information Generating Operation

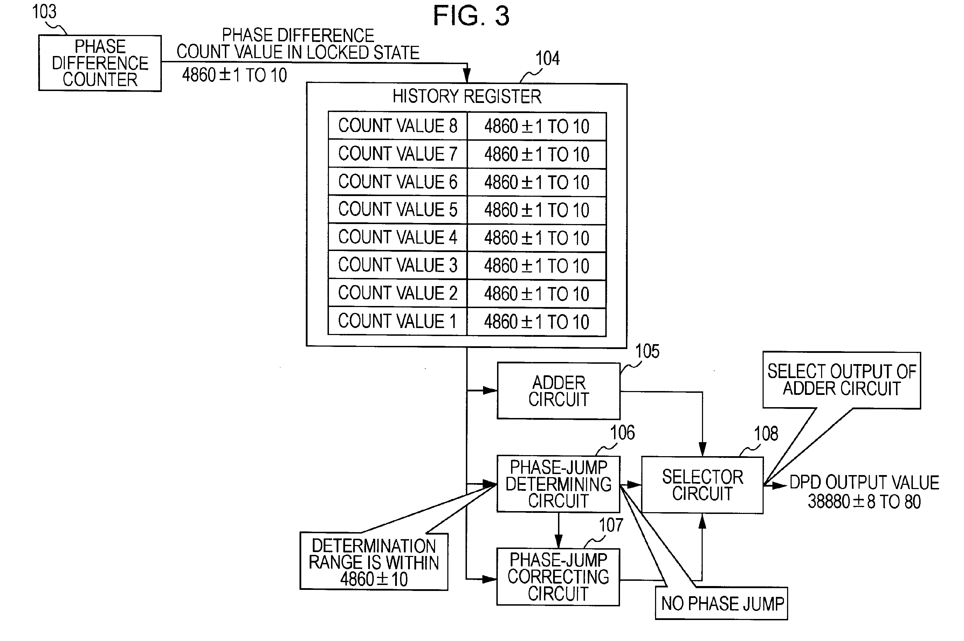

Referring to Figs. 3 to 8, the operation of generating phase difference information using the phase comparator illustrated in Fig. 2 will be specifically described. In Figs. 3 to 8, parts common to those in Fig. 2 are given the same reference numerals.

In the following description, for example, it is assumed that the frequency of the REF input clock signal (which may be called comparison frequency) is 8 kHz, the frequency of the count clock signal is 77.76 MHz, and the number of registers in the history register 104 is 8 (m = 8).

In the above example, when the phase difference relationship in a locked state is 180 degrees, equation 2 gives that the count value obtained by using the count clock signal, which indicates the phase difference between the REF input clock signal and the FB input clock signal in a locked state, is 4860. Thus, for example, it is set that a count value indicating a phase difference within a certain range set in the phase-jump determining circuit 106 is 4860 $\pm$ 1 to 10.

Fig. 3 illustrates the case in which all the count values 1 to 8 stored in the history register 104 are within the range of 4860 $\pm$ 1 to 10.

When the count value counted by the phase difference counter 103 is stored as the count value 8 in the history register 104, the phase-jump determining circuit 106 determines that no phase jump has occurred in the count value 8. Thus, the selector circuit 108 outputs the phase difference information generated by the adder circuit 105. The phase difference information generated by the adder circuit 105 is information indicating a total value 38880 $\pm$ 8 to 80, which is obtained by adding all the count values 1 to 8.

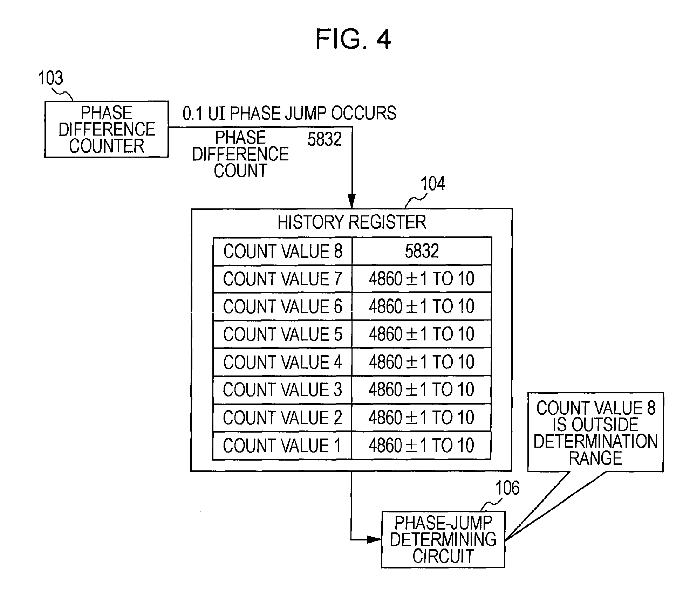

Figs. 4 to 6 illustrate the case in which phase jump has occurred in the REF input clock signal, and the count value 8 becomes 5832, which exceeds the range of 4860 $\pm$ 1 to 10. It is assumed that the count values 1 to 7 already stored in the history register 104 are within the range of 4860 $\pm$ 1 to 10.

Referring to Fig. 4, the phase-jump determining circuit 106 determines that phase jump has occurred in the count value 8, and sends a signal indicating that phase jump has occurred to the phase-jump correcting circuit 107 and the selector circuit 108 (which is not illustrated in Fig. 4).

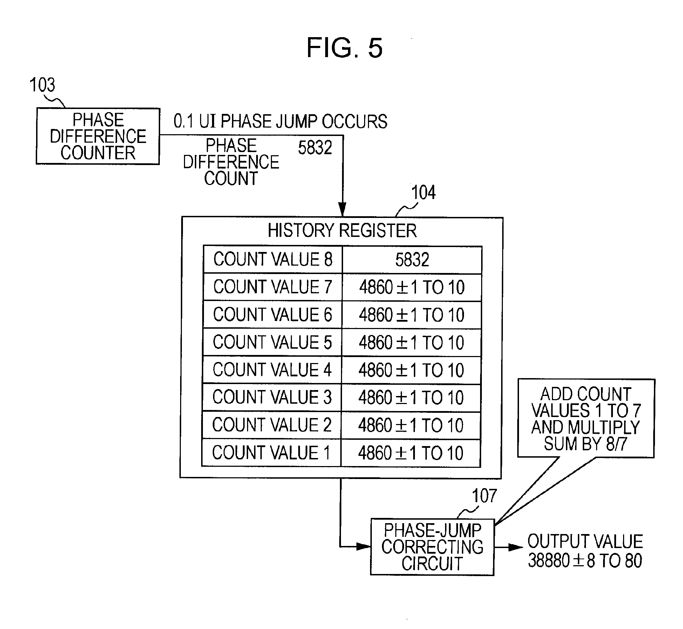

Referring to Fig. 5, when the phase-jump correcting circuit 107 receives the signal indicating that phase jump has occurred in the count value 8, the phase-jump correcting circuit 107 calculates an operation using the count values 1 to 7 excluding the count value 8. Specifically, the value 34020 $\pm$ 7 to 70, which is the sum of count values of the count values 1 to 7, is multiplied by 8/7, which is "the number of count values stored in the history register 104" divided by "the number of count values indicating a phase difference within the certain range". The phase-jump correcting circuit 107 outputs phase difference information indicating the value 38880 $\pm$ 8 to 80, which is the value obtained by calculating the operation.

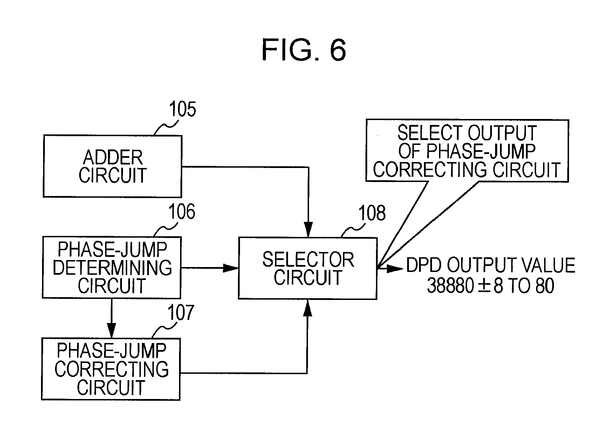

Fig. 6 illustrates the operation of the selector circuit 108 when phase jump has occurred.

When the selector circuit 108 receives a signal indicating that phase jump has occurred from the phase-jump determining circuit 106, the selector circuit 108 performs control to select and output, of the phase difference information generated by the adder circuit 105 and the phase difference information generated by the phase-jump correcting circuit 107, the phase difference information generated by the phase-jump correcting circuit 107. Therefore, the selector circuit 108 outputs the phase difference information indicating the value 38880 $\pm$ 8 to 80, which is the value computed by the phase-jump correcting circuit 107 in Fig. 5.

Accordingly, phase jump occurred in the count value 8 may be prevented from affecting the control operation performed in the oscillator 3. That is, even when instantaneous phase jump occurs in an input clock signal input to the phase comparator 1 in the DPLL circuit, an output clock signal generated by the oscillator 3 may be prevented from suddenly fluctuating due to the occurrence of phase jump.

(4) Modification

In the above-described embodiment, when instantaneous phase jump occurs in an input clock signal input to the phase comparator 1 in the DPLL circuit in a locked state, an output clock signal generated by the oscillator 3 may be prevented from suddenly fluctuating due to the occurrence of phase jump.

In contrast, in this modification, when phase jump in an input clock signal input to a phase comparator is instantaneous, the same operation as the above-described embodiment is performed. Furthermore, a function is added to control an output clock signal output from an oscillator to fluctuate in accordance with phase jump in an input clock signal when this phase jump is not instantaneous, that is, when the input clock signal and the output clock signal consecutively produce phase differences that are not within a certain range.

That is, in this modification, for example, a phase-jump determining circuit determines whether phase jump that occurs in an input clock signal input to a phase comparator is instantaneous, on the basis of count values stored in a history register.

The case in which the input clock signal and the output clock signal consecutively produce phase differences that are not within a certain range is the case in which normal pulling in occurs.

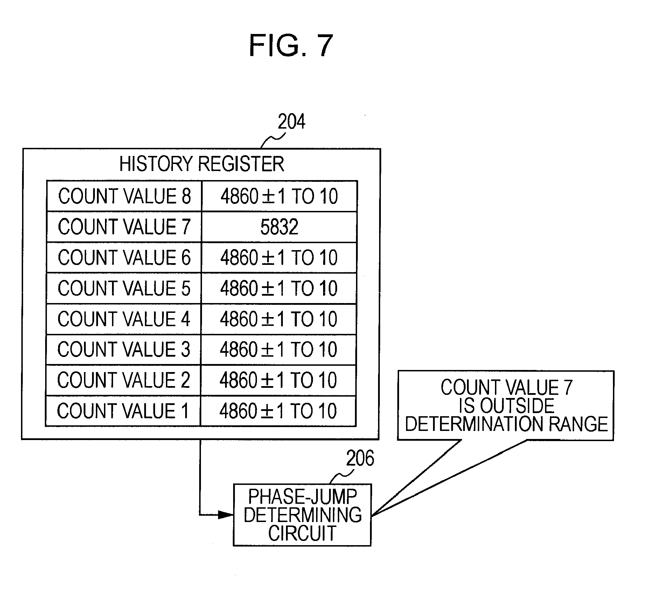

Referring now to Figs. 7 to 9, a specific operation in this modification will be described.

Figs. 7 to 9 illustrate a phase difference counter 203, a history register 204, an adder circuit 205, a phase-jump determining circuit 206, a phase-jump correcting circuit 207, and a selector circuit 208. Parts that are common in Figs. 7 to 9 are given the same reference numerals.

As with the description of the above-described embodiment, it is assumed that the frequency of a REF input clock signal (which may be called comparison frequency) is 8 kHz, the frequency of a count clock signal is 77.76 MHz, the number of registers in the history register 204 is 8 (m = 8), and a count value indicating a phase difference within a certain range set in the phase-jump determining circuit 206 is 4860 $\pm$ 1 to 10.

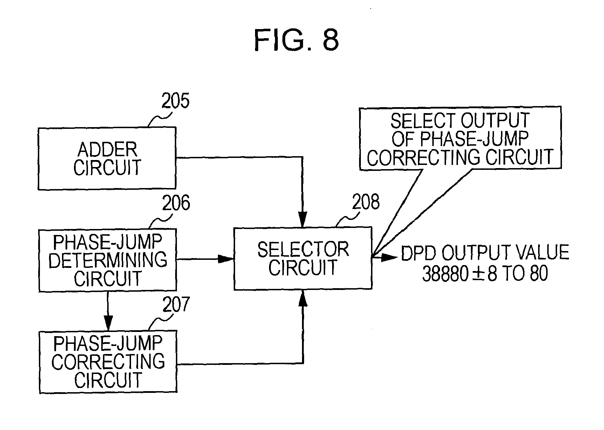

Figs. 7 and 8 illustrate the operation of the phase-jump determining circuit 206 in the case where phase jump that occurs in the REF input clock signal is instantaneous. Specifically, Figs. 7 and 8 illustrate the case in which, by updating count values stored in the history register 204, a count value indicating a phase difference within the certain range (count value 8 in Fig. 7) is stored after a count value indicating a phase difference that is not within the certain range (count value 7 in Fig. 7).

In the foregoing case, the phase-jump determining circuit 206 determines that phase jump has occurred in the count value 7 indicating the count value 5832 (= 4860 + 972) stored in the history register 204. Also, the phase-jump determining circuit 206 determines that no phase jump has occurred in the count value 6 which is before the count value 7 or in the count value 8 which is after the count value 7 since the count values 6 and 8 are each a count value indicating a phase difference that is within the certain range, and determines that the phase jump in the count value 7 is instantaneous.

Therefore, on the basis of the determination result, the phase-jump determining circuit 206 sends a signal indicating that phase jump has occurred to the phase-jump correcting circuit 207 and the selector circuit 208 (which is not illustrated in Fig.7).

Referring to Fig. 8, the adder circuit 205 extracts the count values 1 to 8 stored in the history register 204 illustrated in Fig. 7, and computes the total value by adding the extracted count values 1 to 8. In this case, phase difference information generated by the adder circuit 205 is information indicating the total value 39852 $\pm$ 7 to 70, which is obtained by adding all the count values 1 to 8. Using the computed total value, the adder circuit 205 generates phase difference information, and outputs the phase difference information.

When the phase-jump correcting circuit 207 receives from the phase-jump determining circuit 206 the signal indicating that phase jump has occurred in the count value 7, the phase-jump correcting circuit 207 calculates an operation similar to the case illustrated in Fig. 5 by using the count values 1 to 6 and 8 excluding the count value 7. Specifically, the sum 34020 $\pm$ 7 to 70, which is obtained by adding count values of the count values 1 to 6 and 8, is multiplied by 8/7. The phase-jump correcting circuit 207 outputs phase difference information indicating the value 38880 $\pm$ 8 to 80, which is obtained by calculating the operation.

The selector circuit 208 selects phase difference information to output, on the basis of a signal indicating that no phase jump has occurred or a signal indicating that phase jump has occurred, and a signal indicating that phase differences that are not within the certain range have consecutively occurred in the input clock signal, which are received from the phase-jump determining circuit 206. That is, when no signal indicating that phase jump has occurred is received, when a signal indicating that no phase jump has occurred is received, or when a signal indicating that phase differences that are not within the certain range have consecutively occurred in the input clock signal is received, the selector circuit 208 outputs the phase difference information from the adder circuit 205. In contrast, when a signal indicating that phase jump has occurred is received, the selector circuit 208 outputs the phase difference information from the phase-jump correcting circuit 207.

When the selector circuit 208 receives a signal indicating that phase jump has occurred from the phase-jump determining circuit 206, the selector circuit 208 performs control to select and output, of the phase difference information generated by the adder circuit 205 and the phase difference information generated by the phase-jump correcting circuit 207, the phase difference information generated by the phase-jump correcting circuit 207. Therefore, the selector circuit 208 outputs the phase difference information indicating the value 38880 $\pm$ 8 to 80, which is the value computed by the phase-jump correcting circuit 207.

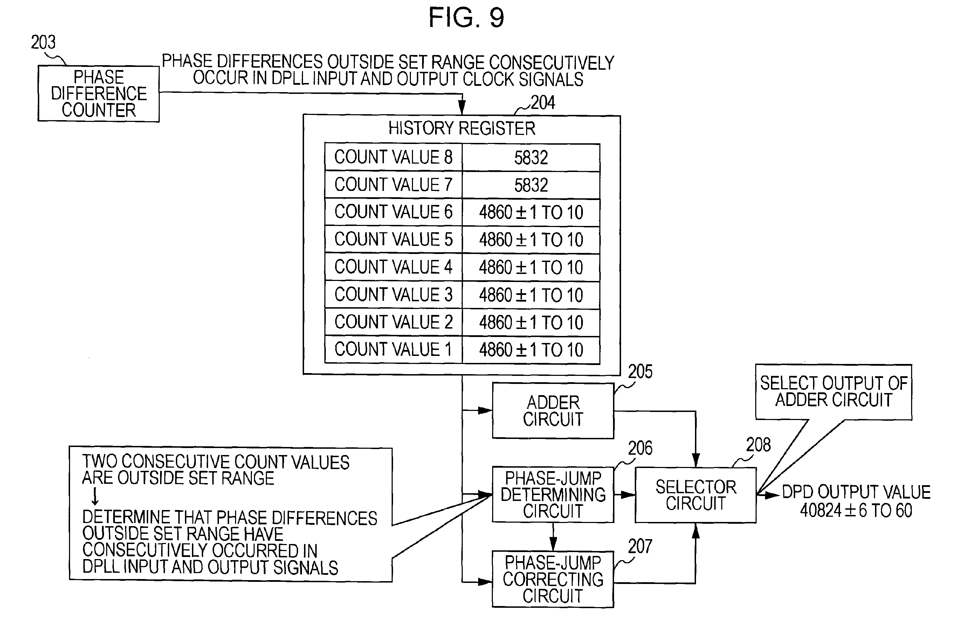

Next, Fig. 9 illustrates the operation of the phase-jump determining circuit 206 in the case where phase jump in the REF input clock signal is not instantaneous, that is, phase differences that are not within the certain range consecutively occur. Specifically, Fig. 9 illustrates the case in which, by updating count values stored in the history register 204, a count value indicating a phase difference that is not within the certain range (count value 8 in Fig. 9) is stored after a count value indicating a phase difference that is not within the certain range (count value 7 in Fig.9).

When the count value counted by the phase difference counter 203 is stored as the count value 8 in the history register 204, the count values in the history register 204 are updated.

The adder circuit 205 extracts the count values 1 to 8 stored in the history register 204, and computes the total value by adding the extracted count values 1 to 8. In this case, phase difference information generated by the adder circuit 205 is information indicating the total value 40824 $\pm$ 6 to 60, which is the value obtained by adding all the count values 1 to 8. Using the computed total value, the adder circuit 205 generates phase difference information, and outputs the phase difference information.

The phase-jump determining circuit 206 extracts the count values stored in the history register 204, and determines that phase jump has occurred in both the count value 7 and the count value 8 that is newly stored by the foregoing update, both of which indicate the count value 5832 (= 4860 + 972). Also, since the phase-jump determining circuit 206 determines that phase jump has occurred in multiple count values that are consecutively stored in the history register 204, the phase-jump determining circuit 206 determines that the phase jump in the count values 7 and 8 is not instantaneous, that is, phase differences that are not within the certain range have consecutively occurred in the input clock signal. A criterion for determining that phase differences that are not within the certain range have consecutively occurred in the input clock signal, that is, the number of times the phase jump has consecutively occurred in count values, can appropriately be set to 2 or greater.

Therefore, on the basis of the determination result, the phase-jump determining circuit 206 sends a signal indicating that phase jump has occurred to the phase-jump correcting circuit 207, and sends a signal indicating that phase differences that are not within the certain range have consecutively occurred in the input clock signal to the selector circuit 208.

Upon receipt of the signal indicating that phase jump has occurred in the count values 7 and 8, the phase-jump correcting circuit 207 calculates an operation using the count values 1 to 6 excluding the count values 7 and 8. Specifically, as in the case of Fig. 5, the sum 29160 $\pm$ 6 to 60, which is obtained by adding count values of the count values 1 to 6, is multiplied by 8/6. The phase-jump correcting circuit 207 outputs phase difference information indicating the value 38880 $\pm$ 8 to 80, which is obtained by calculating the operation.

When the selector circuit 208 receives from the phase-jump determining circuit 206 a signal indicating that phase differences that are not within the certain range have consecutively occurred in the input clock signal, the selector circuit 208 performs control to select and output, of the phase difference information generated by the adder circuit 205 and the phase difference information generated by the phase-jump correcting circuit 207, the phase difference information generated by the adder circuit 205. Therefore, the selector circuit 208 outputs the phase difference information indicating the value 40824 $\pm$ 6 to 60, which is the value computed by the adder circuit 205.

In the above description, on the basis of the determination result, the phase-jump determining circuit 206 sends a signal indicating that phase jump has occurred to the phase-jump correcting circuit 207. Alternatively, when it is determined that phase differences that are not within the certain range have consecutively occurred in the input clock signal, the phase-jump determining circuit 206 may not send a signal indicating that phase jump has occurred to the phase-jump correcting circuit 207.

Accordingly, when phase jump in an input clock signal input to the phase comparator is instantaneous, the same operation as the above-described embodiment is performed. Furthermore, when phase jump in an input clock signal is not instantaneous, that is, when phase differences that are not within the certain range consecutively occur, an output clock signal output from the oscillator may be controlled to fluctuate in accordance with the phase jump.

Accordingly, when instantaneous phase jump occurs in an input clock signal input to the phase comparator in the DPLL circuit, an output clock signal output from the oscillator may be prevented from suddenly fluctuating due to the occurrence of phase jump. When phase differences that are not within the certain range consecutively occur in the input clock signal, an output clock signal output from the oscillator may be controlled so as to suppress the phase differences.

(5) Others

In the above-described embodiment and the modification of the embodiment, when the phase-jump determining circuit determines that phase jump has occurred, the phase-jump determining circuit may alternatively send a signal indicating that phase jump has occurred to the adder circuit. The adder circuit may be controlled not to add the count values stored in the history register upon receipt of the signal indicating that phase jump has occurred.

In the above-described embodiment and the modification of the embodiment, among the count values stored in the history register, a count value indicating a phase difference that is not within a set certain range may alternatively be replaced with a count value indicating a phase difference within the certain range, or may be deleted.

According to an embodiment of the present invention, the occurrence of phase jump in an output clock signal due to the effect of instantaneous phase jump that occurs in an input clock signal in a DPLL circuit may be suppressed.

According to an embodiment of the present invention, the occurrence of phase jump in an output clock signal may be suppressed without changing the setting of the cut-off frequency of a loop filter provided in the DPLL circuit.

**Claims**

1. A control apparatus that performs control to synchronize an output clock signal with an input clock signal, comprising:

   a counting part that counts a phase difference between the input clock signal and the output clock signal;

an extracting part that extracts a count value indicating, of phase differences counted by the counting part, a phase difference within a certain range; and
a clock generating part that generates the output clock signal, the clock generating part being capable of controlling a frequency of the output clock signal on the basis of the extracted count value indicating the phase difference within the certain range.

2. The control apparatus according to claim 1, wherein, when the counting part consecutively counts phase differences that are not within the certain range,
the extracting part further extracts count values indicating the phase differences that are not within the certain range, and
the clock generating part controls the frequency of the output clock signal to be generated, on the basis of the extracted count value indicating the phase difference within the certain range and the extracted count values indicating the phase differences that are not within the certain range.

3. A clock synchronizing method for performing control to synchronize an output clock signal with an input clock signal, comprising:

counting a phase difference between the input clock signal and the output clock signal;
extracting a count value indicating, of counted phase differences, a phase difference within a certain range; and
controlling a frequency of the output clock signal to be generated, on the basis of the extracted count value indicating the phase difference within the certain range.

# FIG. 1

# FIG. 2

REF INPUT
8kHz → [101 ↑ EDGE DETECTOR] → [103 PHASE DIFFERENCE COUNTER]

COUNT CLOCK

FB INPUT
8kHz → [102 ↑ EDGE DETECTOR]

[104 HISTORY REGISTER]
- COUNT VALUE m
- :
- COUNT VALUE 3
- COUNT VALUE 2
- COUNT VALUE 1

[105 ADDER CIRCUIT]

[106 PHASE-JUMP DETERMINING CIRCUIT]

[107 PHASE-JUMP CORRECTING CIRCUIT]

[108 SELECTOR CIRCUIT] → DPD OUTPUT

EP 2 190 119 A1

## FIG. 3

Phase difference counter (103) → Phase difference count value in locked state 4860 ± 1 to 10 → History register (104)

**HISTORY REGISTER**

| COUNT VALUE 8 | 4860 ± 1 TO 10 |
|---|---|
| COUNT VALUE 7 | 4860 ± 1 TO 10 |
| COUNT VALUE 6 | 4860 ± 1 TO 10 |
| COUNT VALUE 5 | 4860 ± 1 TO 10 |
| COUNT VALUE 4 | 4860 ± 1 TO 10 |
| COUNT VALUE 3 | 4860 ± 1 TO 10 |
| COUNT VALUE 2 | 4860 ± 1 TO 10 |
| COUNT VALUE 1 | 4860 ± 1 TO 10 |

ADDER CIRCUIT (105)

SELECT OUTPUT OF ADDER CIRCUIT

PHASE-JUMP DETERMINING CIRCUIT (106)

SELECTOR CIRCUIT (108) → DPD OUTPUT VALUE 38880 ± 8 TO 80

DETERMINATION RANGE IS WITHIN 4860 ± 10

PHASE-JUMP CORRECTING CIRCUIT (107)

NO PHASE JUMP

EP 2 190 119 A1

# FIG. 4

103

```
PHASE
DIFFERENCE
COUNTER
```

0.1 UI PHASE JUMP OCCURS

PHASE
DIFFERENCE
COUNT     5832

104

| HISTORY REGISTER | |
|---|---|
| COUNT VALUE 8 | 5832 |
| COUNT VALUE 7 | 4860 ± 1 TO 10 |
| COUNT VALUE 6 | 4860 ± 1 TO 10 |
| COUNT VALUE 5 | 4860 ± 1 TO 10 |
| COUNT VALUE 4 | 4860 ± 1 TO 10 |
| COUNT VALUE 3 | 4860 ± 1 TO 10 |
| COUNT VALUE 2 | 4860 ± 1 TO 10 |
| COUNT VALUE 1 | 4860 ± 1 TO 10 |

COUNT VALUE 8
IS OUTSIDE
DETERMINATION
RANGE

106

```
PHASE-JUMP
DETERMINING
CIRCUIT
```

EP 2 190 119 A1

# FIG. 5

103

| PHASE DIFFERENCE COUNTER |
|---|

0.1 UI PHASE JUMP OCCURS

PHASE DIFFERENCE COUNT    5832

104

HISTORY REGISTER

| COUNT VALUE 8 | 5832 |
|---|---|
| COUNT VALUE 7 | 4860 ± 1 TO 10 |
| COUNT VALUE 6 | 4860 ± 1 TO 10 |
| COUNT VALUE 5 | 4860 ± 1 TO 10 |
| COUNT VALUE 4 | 4860 ± 1 TO 10 |
| COUNT VALUE 3 | 4860 ± 1 TO 10 |
| COUNT VALUE 2 | 4860 ± 1 TO 10 |
| COUNT VALUE 1 | 4860 ± 1 TO 10 |

ADD COUNT VALUES 1 TO 7 AND MULTIPLY SUM BY 8/7

107

| PHASE-JUMP CORRECTING CIRCUIT |
|---|

OUTPUT VALUE 38880 ± 8 TO 80

14

# FIG. 6

105

ADDER CIRCUIT

106

PHASE-JUMP DETERMINING CIRCUIT

107

PHASE-JUMP CORRECTING CIRCUIT

108

SELECTOR CIRCUIT

SELECT OUTPUT OF PHASE-JUMP CORRECTING CIRCUIT

DPD OUTPUT VALUE 38880 ± 8 TO 80

# FIG. 7

204

| HISTORY REGISTER | |
|---|---|
| COUNT VALUE 8 | 4860 ± 1 TO 10 |
| COUNT VALUE 7 | 5832 |
| COUNT VALUE 6 | 4860 ± 1 TO 10 |
| COUNT VALUE 5 | 4860 ± 1 TO 10 |
| COUNT VALUE 4 | 4860 ± 1 TO 10 |
| COUNT VALUE 3 | 4860 ± 1 TO 10 |
| COUNT VALUE 2 | 4860 ± 1 TO 10 |
| COUNT VALUE 1 | 4860 ± 1 TO 10 |

COUNT VALUE 7
IS OUTSIDE
DETERMINATION RANGE

206

PHASE-JUMP
DETERMINING
CIRCUIT

# FIG. 8

## FIG. 9

PHASE DIFFERENCES OUTSIDE SET RANGE CONSECUTIVELY OCCUR IN DPLL INPUT AND OUTPUT CLOCK SIGNALS

203 — PHASE DIFFERENCE COUNTER

204 — HISTORY REGISTER

| | |
|---|---|
| COUNT VALUE 8 | 5832 |
| COUNT VALUE 7 | 5832 |
| COUNT VALUE 6 | 4860 ±1 TO 10 |
| COUNT VALUE 5 | 4860 ±1 TO 10 |
| COUNT VALUE 4 | 4860 ±1 TO 10 |
| COUNT VALUE 3 | 4860 ±1 TO 10 |
| COUNT VALUE 2 | 4860 ±1 TO 10 |
| COUNT VALUE 1 | 4860 ±1 TO 10 |

205 — ADDER CIRCUIT

206 — PHASE-JUMP DETERMINING CIRCUIT

207 — PHASE-JUMP CORRECTING CIRCUIT

208 — SELECTOR CIRCUIT

SELECT OUTPUT OF ADDER CIRCUIT

DPD OUTPUT VALUE 40824 ±6 TO 60

TWO CONSECUTIVE COUNT VALUES ARE OUTSIDE SET RANGE → DETERMINE THAT PHASE DIFFERENCES OUTSIDE SET RANGE HAVE CONSECUTIVELY OCCURRED IN DPLL INPUT AND OUTPUT SIGNALS

# FIG. 10

HWY LINE

DPLL

HWY INT 5

8kHz

DPD 6

DLF 7

NCO 8

3.84MHz
SYSTEM
CLK OUT

1/N 9

# FIG. 11

REF INPUT
8kHz

FB INPUT
8kHz

PHASE DIFFERENCE
COUNT CLOCK

8kHz

PHASE DIFFERENCE
COUNT VALUE

77.76MHz
COUNT CLOCK
FREQUENCY

# FIG. 12

EP 2 190 119 A1

# FIG. 13

EP 2 190 119 A1

**303**

| PHASE DIFFERENCE COUNTER |
|---|

PHASE DIFFERENCE COUNT VALUE
IN LOCKED STATE
4860 ± 1 TO 10

**304**

### HISTORY REGISTER

| COUNT VALUE 8 | 4860 ± 1 TO 10 |
|---|---|
| COUNT VALUE 7 | 4860 ± 1 TO 10 |
| COUNT VALUE 6 | 4860 ± 1 TO 10 |
| COUNT VALUE 5 | 4860 ± 1 TO 10 |
| COUNT VALUE 4 | 4860 ± 1 TO 10 |
| COUNT VALUE 3 | 4860 ± 1 TO 10 |
| COUNT VALUE 2 | 4860 ± 1 TO 10 |
| COUNT VALUE 1 | 4860 ± 1 TO 10 |

**305**

| ADDER CIRCUIT |
|---|

DPD OUTPUT
38880 ± 8 TO 80

# FIG. 14

303

PHASE
DIFFERENCE
COUNTER

0.1 UI PHASE JUMP OCCURS
IN LOCKED STATE

304

HISTORY REGISTER

| COUNT VALUE 8 | 4860 + 972 |
| COUNT VALUE 7 | 4860 ± 1 TO 10 |
| COUNT VALUE 6 | 4860 ± 1 TO 10 |
| COUNT VALUE 5 | 4860 ± 1 TO 10 |
| COUNT VALUE 4 | 4860 ± 1 TO 10 |
| COUNT VALUE 3 | 4860 ± 1 TO 10 |
| COUNT VALUE 2 | 4860 ± 1 TO 10 |
| COUNT VALUE 1 | 4860 ± 1 TO 10 |

305

ADDER
CIRCUIT

DPD OUTPUT
39852 ± 7 TO 70

972 COUNTS GREATER THAN
NORMAL LOCKED STATE

EP 2 190 119 A1

Europäisches
Patentamt

European
Patent Office

Office européen
des brevets

## EUROPEAN SEARCH REPORT

Application Number

EP 09 17 4087

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 181 175 B1 (WOLF MICHAEL [DE]) 30 January 2001 (2001-01-30) * column 1, line 66 - column 4, line 23; figures * ----- | 1,3 | INV. H03L7/085 H03L7/093 |

TECHNICAL FIELDS
SEARCHED    (IPC)

H03L

The present search report has been drawn up for all claims

| Place of search | Date of completion of the search | Examiner |
|---|---|---|
| The Hague | 19 March 2010 | Balbinot, Hervé |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

........................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 09 17 4087

This annex lists the patent family members relating to the patent documents cited in the above-mentioned European search report.
The members are as contained in the European Patent Office EDP file on
The European Patent Office is in no way liable for these particulars which are merely given for the purpose of information.

19-03-2010

| Patent document cited in search report | | Publication date | | Patent family member(s) | | Publication date |
|---|---|---|---|---|---|---|
| US 6181175 | B1 | 30-01-2001 | CA | 2276815 | A1 | 07-01-2000 |
| | | | DE | 19830260 | A1 | 13-01-2000 |
| | | | EP | 0973263 | A2 | 19-01-2000 |

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008296635 A

- JP 2002152736 A